Europäisches Patentamt

European Patent Office

Office européen des brevets

(19)

(11) Numéro de publication: **0 285 495 B1**

(12) **FASCICULE DE BREVET EUROPEEN**

(45) Date de publication de fascicule du brevet: **25.08.93**

(51) Int. Cl.5: **H03H 17/06**, H03H 17/02, H04B 1/66

(21) Numéro de dépôt: **88400672.7**

(22) Date de dépôt: **21.03.88**

(54) **Système de traitement numérique de signal à bancs de filtres.**

(30) Priorité: **24.03.87 FR 8704076**

(43) Date de publication de la demande:
**05.10.88 Bulletin 88/40**

(45) Mention de la délivrance du brevet:
**25.08.93 Bulletin 93/34**

(84) Etats contractants désignés:
**DE GB NL**

(56) Documents cités:

**IEEE TRANSACTIONS ON ACOUSTICS, SPEECH AND SIGNAL PROCESSING, vol. ASSP-34, no. 5, octobre 1986, pages 1090-1096, IEEE, New York, US; R. COX: "The design of uniformly and nonuniformly spaced pseudoquadrature mirror filters"**

**PROCEEDINGS OF THE INTERNATIONAL CONFERENCE ON ACOUSTICS, SPEECH AND SIGNAL PROCESSING, San Diego, 19-21 mars 1984, vol. 1, pages 11.3.1-11.3.4, IEEE, New York, US; H. NUSSBAUMER et al.: "Computationally efficient OMF filter banks"**

**PROCEEDINGS OF THE INTERNATIONAL**

**CONFERENCE ON ACOUSTICS, SPEECH AND SIGNAL PROCESSING, ICASSP'84, San Diego, vol. 1, pages 11.4.1-11.4.3; IEEE, New York, US; M. BEACKEN: "Efficient implementation of highly variable bandwidth filter banks with highly decimated output channels"**

(73) Titulaire: **FRANCE TELECOM Etablissement autonome de droit public, 6, Place d'Alleray F-75015 Paris(FR)**

(72) Inventeur: **Rault, Jean-Bernard 38-40 Rue du Général Leclerc F-92131 Issy les Moulineaux(FR)**

(74) Mandataire: **Fort, Jacques et al CABINET PLASSERAUD 84, rue d'Amsterdam F-75009 Paris (FR)**

Rank Xerox (UK) Business Services
(3.10/3.6/3.3.1)

## Description

L'invention concerne les systèmes de traitement numérique du signal du type comportant un banc de filtres d'analyse de signal permettant de décomposer un signal entrant x, occupant une bande de fréquence déterminée et échantillonné, en N signaux (N étant un nombre entier) dans des sous-bandes adjacentes et/ou un banc de synthèse permettant de reconstituer le signal entrant à partir des signaux dans les sous-bandes adjacentes.

L'invention trouve une application particulièrement importante dans le domaine des télécommunications sous forme numérique où de nombreuses études ont déjà été consacrées à la réduction du débit numérique nécessaire pour transmettre des signaux sonores qui ont d'abord été la parole, puis des voies son de moyenne et de haute qualité.

Une des approches utilisées pour atteindre ce résultat est constituée par le système concerné par l'invention. Elle fait appel aux techniques de codage en sous-bandes. Le signal x à transmettre est découpé à l'émission en un nombre N de sous-bandes de fréquence adjacentes les unes aux autres. Le signal dans chaque sous-bande est ensuite sous-échantillonné et transmis à sa fréquence de Nyquist avec un codage et un débit particuliers.

Dans le récepteur du système le signal est reconstitué par sur-échantillonnage (avec adjonction de zéros) traitement des différentes sous-bandes et sommation des signaux fournis. Le débit total utilisé en ligne peut être réduit du fait qu'à chaque sous-bande est affecté un débit numérique particulier.

L'application directe du principe exposé ci-dessus fait apparaître des repliements de spectre lors du sous-échantillonage et du sur-échantillonnage. Si ces repliements ne sont pas éliminés à la réception, ils provoquent une dégradation du signal qui s'ajoute à celles dues au codage et au décodage.

Divers procédés ont déjà été proposés pour éliminer ou réduire les phénomènes de repliement. En particulier, l'article "Computationaly efficient QMF filter banks" par Nussbaumer et autres, Proceedings of ICASSP 1984, décrit un système de transmission à N sous-bandes d'égales largeurs, à découpage du signal à transmettre à l'aide de bancs de filtres se rapprochant de filtres miroirs en quadrature, dits QMF, tous réalisés à partir d'un filtre prototype par translation en fréquence et tous d'égales largeurs.

Le système décrit dans l'article ci-dessus mentionné ainsi que les variantes décrites dans d'autres articles, par exemple "Polyphase quadrature filters - a new subband coding technique" par H. H. Rothweiler, proceedings of ICASSP 1984, conserve un codage classique du signal en N sous-bandes.

On ne peut donner aux sous-bandes des largeurs inégales qu'avec l'utilisation de filtres QMF en redécoupant une ou plusieurs des sous-bandes obtenues à une étape i en deux sous-bandes à l'étape (i + 1), suivant un processus en arbre. Si on désigne alors par fe la fréquence initiale d'échantillonnage du signal à transmettre, la largeur en fréquence des sous-bandes est obligatoirement un multiple de $fe/2^{**(p+1)}$ pour un processus à p étapes. Cette limitation est très gênante car souvent il serait souhaitable d'utiliser un découpage différent pour arriver à un résultat optimal, par exemple :

[0, fe/12]

[fe/12, fe/6]

[fe/6, fe/3]

[fe/3, fe/2]

De plus, les sous-bandes obtenues à l'étape i et transmises directement doivent être filtrées par des filtres qui prennent en compte les réponses en fréquence des filtres QMF utilisés aux étages suivants. Dans la pratique ces filtres sont remplacés par des éléments de retard de sorte qu'il n'est plus possible de récupérer de façon parfaite le signal entrant x et il est indispensable de prévoir, dans le récepteur du système, des filtres de compensation non triviaux pour toutes les sous-bandes transmises directement à partir des étapes i autres que La dernière étape si l'on veut récupérer de façon parfaite le signal entrant x.

On connaît également (FR-A-2 577 084) un système de traitement numérique du type ci-dessus défini, dont tous les filtres sont obtenus à partir d'un filtre prototype, qui fait intervenir un terme de phase qui dépend du nombre de coefficients du filtre prototype. On peut ainsi écarter la contrainte que représente, dans le système de Nussbaumer et autre, la relation entre le nombre de sous-bandes et le nombre de coefficients du filtre prototype. Mais les autres limitations de l'art antérieur et notamment la limitation sur la largeur relative des sous-bandes, subsistent entièrement.

On connaît enfin "PROCEEDINGS OF THE INTERNATIONAL CONFERENCE ON ACOUSTICS, SPEECH AND SIGNAL PROCESSING, ICASSP 84, San Diego, California, 19- 21 mars 1984, vol. 1, pages 11.4.1-11.4.3, IEEE, New York, US ; M. BEACKEN : "Efficient implementation of highly variable bandwidth filter banks with highly decimated output channels", un banc de filtre passe-bande dans lequel on utilise des largeurs de canal arbitraires en les synthétisant par combinaison de séquences de canaux adjacents dans le spectre. Les indications données dans ce document restent très vagues et en particulier ne font pas mention de sous-échantillonnages adaptés à chaque largeur de filtre. Et l'homme de métier pouvait craindre que l'utilisation de cette technique ne dégrade le signal à traiter.

Par l'article paru dans IEEE TRANSACTIONS ON ACOUSTICS, SPEECH AND SIGNAL PROCESSING, Vol. ASSP-34, N$^r$5, oct. 1986, p. 1090-1096, IEEE, New-York, de R. COX : "The design of uniformly and non uniformly spaced pseudo-quadrature mirror filters", il est par ailleurs connu de regrouper des filtres du banc d'analysé pour former des filtres composés comportant des nombres de filtres différents d'un filtre composé à l'autre.

La présente invention vise à fournir un système de traitement numérique du type ci-dessus défini permettant de découper un signal en sous-bandes d'inégales largeurs et écartant les contraintes sur la largeur des sous-bandes qu'implique la méthode de découpage en arbre et ce, sans exiger des filtres de compensation complexes.

Elle vise notamment à permettre la réalisation d'un système dont les filtres adjacents correspondent à des sous-bandes dont le choix présente beaucoup plus de liberté que dans les systèmes antérieurs, ce qui permet de constituer le banc avec un nombre de sous-bandes optimal.

Dans ce but l'invention propose notamment un système de traitement numérique du signal, comprenant un banc de filtres d'analyse ($H_K$) permettant de décomposer un signal entrant x, occupant une bande déterminée fe/2 et échantillonné à la fréquence fe en un nombre entier N de signaux dans des sous-bandes adjacentes et échantillonnés et/ou un banc de filtres de synthèse ($H'_K$) permettant de reconstituer le signal entrant à partir desdits signaux dans les sous-bandes, lesdits bancs de filtres étant formés chacun d'un nombre N pair de filtres de même largeur réalisés chacun par modulation d'un filtre prototype passe-bas ayant une réponse impulsionnelle symétrique répondant aux conditions de quadrature dans une bande ne débordant que sur les filtres immédiatement adjacents et ayant une réponse nulle en dehors de cette bande, dans lequel les filtres ($H_K$) du banc d'analyse sont regroupés pour constituer M filtres composés ($Gi$) comportant des nombres $\ell i$ de filtres ($H_K$) différents d'un filtre ($Gi$) à l'autre, les valeurs $Ni = N/\ell i$ étant entières ; le sous-échantillonnage est effectué à une fréquence distincte fe/Ni pour chaque filtre ($Gi$) ; et tous les filtres de même largeur sont regroupés de façon que les facteurs de sous-échantillonnage ($Ni$) remplissent la condition

$$Ni = m_i \cdot Nm$$

où Nm est le plus petit facteur de sous-échantillonage du banc de filtres Gi et $m_i$ est un nombre entier, pour permettre d'effectuer tous les calculs à la même fréquence, les filtres du banc de synthèse ayant une constitution symétrique.

Le banc d'analyse peut être constitué par : un réseau polyphasé à M entrées ; des moyens pour effectuer sur les 2N sorties du réseau une transformée en cosinus impaire à 2N dimensions ; et des moyens de nouveau sous-échantillonnage et de sommation des N sorties x desdits moyens de transformée. Le banc de synthèse a alors une constitution sensiblement symétrique.

Divers groupements de filtres de même largeur sont possibles. Dans le cas d'un système destiné à la transmission d'un signal son haute qualité, ayant habituellement une bande passante allant de 0 à 15 kHz, échantillonné à fe = 32 kHz, le filtre prototype est avantageusement un filtre passe-bas non récursif à phase linéaire de bande passante [0,1 kHz] à 96 coefficients et quatre sous-bandes, dont trois sont en progression géométrique de raison 2, constituées à partir de huit filtres de même largeur.

L'invention sera mieux comprise à la lecture de la description qui suit de modes particuliers de réalisation, donnés à titre d'exemples non limitatifs. La description se réfère aux dessins qui l'accompagnent dans lesquels :

- la figure 1 est un schéma synoptique de principe d'un système classique d'analyse-synthèse ;
- la figure 2 est une représentation du module $H_K$ de la réponse d'un filtre d'analyse type, en fonction de la fréquence ;
- la figure 3 est une représentation de la sortie $Y_K(\omega)$ du banc de filtres d'analyse de la figure 1, échantillonné par un facteur N, pour N = 8 et K = 3;
- la figure 4, similaire à la figure 1, montre la constitution de principe d'un système d'analyse-synthèse suivant l'invention ;
- la figure 5, similaire à la figure 3, montre la réponse en fréquence d'un banc d'analyse suivant un mode particulier de réalisation de l'invention, pour N = 8, Ki = 1 et $\ell i$ = 2;
- les figures 6 et 7 montrent des répartitions possibles de filtres de même largeur, respectivement dans le banc d'analyse et le banc de synthèse d'un système suivant un mode particulier de réalisation de l'invention ;

- les figures 8 et 9 sont des schémas synoptiques montrant une implémentation possible du banc d'analyse et du banc de synthèse dans un système suivant l'invention ;
- les figures 10, 11 et 12 montrent respectivement, en fonction de la fréquence, le carré du module $G_i^2$-$(\omega)$ de trois filtres d'inégales largeurs constitués à partir de huit filtres d'égale largeur ; le carré du module $H_K^2(\omega)$ des deux premiers des huit filtres ; et le carré du module du filtre prototype ;
- les figures 13A et 13B montrent la façon dont s'effectue le filtrage du signal à émettre par le réseau polyphasé de la figure 8, respectivement pour p = 0 et p = 1 ;
- les figures 14A et 14B montrent l'obtention des huits sorties à la fréquence 16 kHz obtenue à partir de la transformée en cosinus impaire $c_{K, 2b+p}$, respectivement pour les valeurs p = 0 et p = 1 ;
- la figure 15 montre l'obtention des quatre sorties en sous-bandes aux fréquences 4 kHz, 4 kHz, 8 kHz et 16 kHz par sommation ;
- la figure 16 représente le montage de synthèse symétrique du montage de la figure 15, fournissant les signaux $\tilde{Y}k$ ;
- les figures 17A et 17B, similaires aux figures 14A et 14B, représentent l'action de la transformée en cosinus impaire $c'_{K, 2b+p}$ sur les huit signaux fournis par la synthèse de la figure 16, respectivement pour les valeurs p = 0 et p = 1 ;
- les figures 18A et 18B, symétriques des figures 13A et 13B, représentent l'obtention du signal reconstitué par synthèse $\hat{x}(2m+p)$ à partir du réseau polyphasé, respectivement pour les valeurs p = 0 et p = 1.

Avant de définir l'invention, on rappellera la constitution d'un système de traitement numérique du type ci-dessus défini et les équations qu'il met en oeuvre.

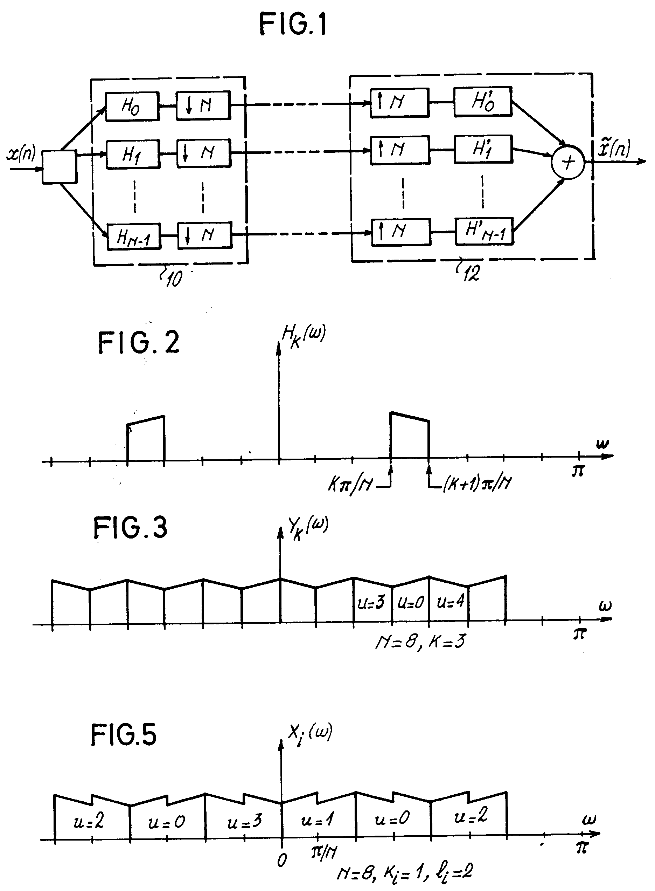

L'analyse et la synthèse d'un signal x(n) échantillonné à fréquence fe et de bande passante fe/2 (qu'on désignera par $\pi$ en se ramenant aux fréquences normalisées), sa transmission et sa restitution sous forme d'un signal reconstitué x(n) s'effectuent en utilisant un ensemble de filtrage et de sous-échantillonnage 10 à l'émission, un ensemble de sur-échantillonnage, de filtrage et de sommation 12 à la réception (figure 1).

Si on considère un filtre $H_K$ de bande passante $[K\pi/N, (K+1)\pi/N]$ où N est un nombre entier et où K est un entier inférieur ou égal à N-1, le signal X soumis au filtrage, puis à sous-échantillonnage (ou décimation) par le facteur N devient $Y_K$ donné par :

$$Y_K = \frac{1}{N} \sum_{u=0}^{N-1} X[Z \exp(-j2\pi u/N)].H_K[Z \exp(-j2\pi u/N)]$$

Z représente la variable transformée et les lettres majuscules X et $Y_K$ les transformées en Z, suivant la notation habituelle.

La figure 3 montre, dans le cas particulier de N = 8 et K = 3, la sortie $Y_K(\omega)$ de l'ensemble d'émission, après filtrage et sous-échantillonnage.

Pour u = 0 on retrouve le signal utile. Les (N-1) signaux translatés correspondent aux valeurs u = 1 ... N-1. Si la réponse impulsionnelle du filtre est du genre montré en figure 2, à flancs raides, il n'y a pas de recouvrement entre les signaux correspondant aux diverses valeurs de u.

L'invention part de l'hypothèse qu'il sera possible -ce qui n'est nullement évident à priori- d'associer des filtres adjacents d'égale largeur d'un banc pour constituer un banc formé de filtres ayant des bandes de largeurs différentes et ce sans faire apparaître des problèmes graves de compensation de repliements de spectre de sous-échantillonnage et/ou d'un volume de calcul excessif.

Dans le cas d'un banc de N filtres adjacents $(H_K)$ où chaque filtre $H_K$ occupe la bande $[K\pi/N, (K+1)\pi/N]$, la réponse du filtre obtenu en mettant en parallèle $\ell i$ filtres adjacents est :

$$G_i = \sum_{p=K}^{K+\ell i-1} H_p$$

Le filtre de caractéristiques $G_i$ a une bande passante $[K\pi/N, (K+\ell i-1)\pi/N]$ et une largeur en fréquence $\ell i\pi/N$.

Ce filtre peut être utilisé pour le sous-échantillonnage du signal à condition que $N/\ell i$ soit un nombre entier Ni. On peut alors sous-échantillonner par le facteur Ni si la bande passante du filtre composite constitué de $\ell i$ filtres adjacents est :

4

$[K_i.\pi/Ni, K_{i+1}\pi/Ni]$.

En résumé, on voit déjà qu'il est possible d'utiliser le filtre Gi ci-dessus pour sous-échantillonner un signal par un facteur Ni égal à $N/\ell i$ avec $K_i = 0,..., N_{i-1}$ à condition que $K/N = Ki/Ni \rightarrow K = \ell iKi$.

Dans le système connu montré en figure 1, chaque banc est constitué de N filtres pseudo-QMF obtenus à partir d'un filtre prototype unique H et ayant tous la même largeur. Le banc de filtres d'analyse ($H_K$) (où $K = 0, 1, .., N\text{-}1$) permet de découper le signal d'entrée x(n) en N sous-bandes d'égale largeur. Le banc de filtres de synthèse ($H'_K$) permet de reconstituer le signal sous la forme $\hat{x}(n)$ dans un sommateur.

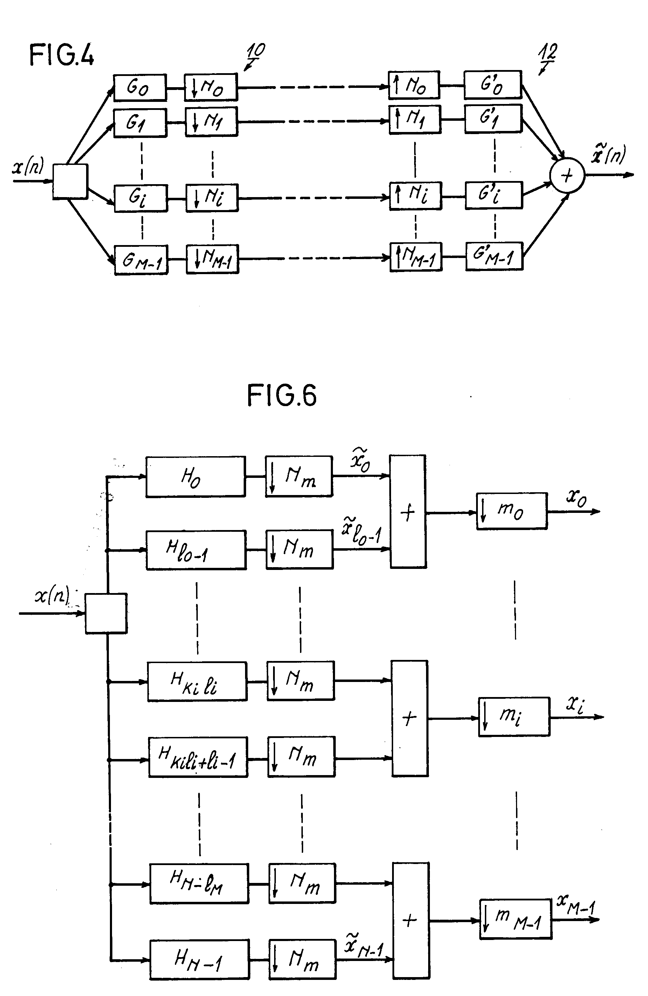

L'invention permet, comme on le démontrera plus loin, moyennant le respect de conditions qui seront définies, de constituer deux bancs de filtres adjacents d'inégales largeurs (Gi) et (G'i) (figure 4) par sommation de filtres $H_K$ et $H'_K$ adjacents appartenant aux bancs ($H_K$) et ($H'_K$).

Cette sommation s'effectue suivant les équations :

$$Gi = (1/\ell i) \sum_{K=\ell iKi}^{\ell iKi+\ell i-1} H_K, \text{ et}$$

$$G'i = \sum_{K=\ell iKi}^{\ell iKi+\ell i-1} H'_K,$$

lorsqu'il y a sommation de $\ell i$ filtres pour former des bancs de M filtres adjacents, avec :

$i = 0, ..., M\text{-}1$

$K = 0, ..., N\text{-}1$

$$\ell i = N/Ni \text{ où } Ni \in \mathbb{N} \qquad \text{et } Ki < Ni$$

Les bancs de filtres (Gi) et (G'i) permettent l'analyse d'un signal en M sous-bandes, cette fois d'inégale largeur en fréquence, et sa synthèse, chaque sous-bande d'indice i devant être sous-échantillonnée par un facteur particulier Ni et non pas par un facteur commun N, avant transmission.

Avant de montrer qu'il est possible de regrouper des filtres de type connus constituant les bancs ($H_K$) et ($H'_K$) pour constituer un banc (Gi)ou (G'i) en éliminant les termes de repliement, il faut rappeler la relation entre la caractéristique $H_K(Z)$ de ces filtres et celle H(Z) d'un filtre prototype.

$H_K(Z) = H[Zexp(2K+1)\pi/2N].exp(-j\phi_K) + H[Zexp(j(2K+1)\pi/2N]exp(j\phi_K)$
$H'_K(Z) = H[Zexp(-j(2K+1)\pi/2N].exp(-j\phi'_K) + H[Zexp(j(2K+1)\pi/2N]exp(j\phi'_K)$
avec $\phi_K = [(2K+1)\pi/4] + C_K \quad \phi'_K = -[(2K+1)\pi/4] + C_K$

Les systèmes de l'art antérieur imposent des conditions, au moins sur $C_K$ : par exemple le système de Nussbaumer et al impose $C_K = 0$, le nombre de coefficient du filtre NF devant être de la forme $2pN + 1$ (p étant un nombre entier).

Il faut également que le filtre prototype H vérifie les conditions classiques de quadrature :

$H^2(\omega\text{-}\pi/N) + H^2(\omega+\pi/N) = 1$ pour $\omega$ $[0,\pi/2N]$ (5)

$H^2(\omega) = 0$ pour $\omega$ $[\pi/N, \pi]$ (6)

qui seront conservées pour la mise en oeuvre de l'invention.

On considèrera maintenant d'abord la ième branche du système de la figure 4, puis la (i + 1)ème branche.

ième BRANCHE

Pour la branche i, $y_i$ et $u_i$ s'écrivent :

$$\text{Yi(Z)} = \text{Xi}(Z^{Ni})$$

$$= (1/Ni) \sum_{u=0}^{Ni-1} X[Z\exp(-j2\pi u/Ni)].Gi[Z\exp(-j2\pi u/Ni)]$$

$$\text{Ui(Z)} = \text{Yi(Z)G'i(Z)}$$

$$= (1/Ni) \sum_{u=0}^{Ni-1} X[Z\exp(-j2\pi u/Ni)].$$

$$Gi[Z\exp(-j2\pi u/Ni)]G'i(Z)$$

La raideur des filtres $H'_K$ composant le filtre $G'i$ est telle que ce dernier, lorsqu'il filtre Yi(Z), ne laisse passer que le signal utile obtenu pour u = 0 et les quatre bandes adjacentes au signal utile obtenues :
- pour u = Ni-Ki et u = Ni-Ki-1 pour la partie négative du spectre, et
- pour u = Ki et u = Ki + 1 pour la partie possitive du spectre,

comme le montre la figure 5. On a donc :

Ui(Z) = 1/Ni[X(Z)Gi(Z)G'i(Z)] + 1/Ni{X[Zexp(-j2πKi/Ni)].Gi[Zexp(-j2π(Ki/Ni)] + X[Zexp(-j2π(Ki + 1)/Ni)].Gi-[Zexp(-j2π(Ki + 1)/Ni)] + X[Zexp(j2πKi/Ni)]Gi[Zexp(j2πKi/Ni)] + X[Zexp(j2π(Ki + 1)/Ni)] Gi[Zexp(j2π(Ki + 1)/Ni)]}G'i(Z)

Le premier terme de Ui(Z) représente le signal utile. Les quatre autres termes sont des termes de repliements spectraux qu'il faut éliminer.

Sachant que N = ℓi.Ni, il vient :

Ui(Z) = ℓi/N[X(Z).Gi(Z).G'i(Z)] + ℓi/N{X[Zexp(-j2πℓiKi/N)]Gi[Zexp(-j2πℓiKi/N)] + X[Zexp(-j2π(ℓiKi + ℓi)/N)] Gi[Zexp(-j2π(ℓiKi + ℓi)/N)] + X[Zexp(j2πℓiKi/N)]Gi[Zexp(j2πℓiKi/N)] + X[Zexp(j2π(ℓiKi + ℓi)/N)] Gi[Zexp(j2π-(ℓiKi + ℓi)/N))]}G'i(Z)     (7)

Le filtre Gi (ou G'i) étant constitué de filtres adjacents $H_K$ (ou $H'_K$) on a :

$$\text{Gi(Z)} = 1/\ell i \sum_{K=Ki\ell i}^{Ki\ell i+\ell i-1} H_K(Z)$$

$$= 1/\ell i \sum_{K=Ki\ell i}^{Ki\ell i+\ell i-1} [H[Z\exp(-j(2K+1)(\pi/2N))]\exp(-j\varphi K)]$$

$$+ H[Z\exp(j(2K+1)(\pi/2N)]\exp(j\varphi_K)]$$

et

$$\text{G'i(Z)} = \sum_{K=Ki\ell i}^{Ki\ell i+\ell i-1} H'_K(Z)$$

$$= \sum_{K=Ki\ell i}^{Ki\ell i+\ell i-1} [H[Z\exp(-j(2K+1)(\pi/2N))]\exp(-j\varphi'K)] +$$

$$H[Z\exp(j(2K+1)(\pi/2N)]\exp(j\varphi'_K)]$$

En reportant ces deux équations dans (7) la somme des quatre termes de repliements à annuler, Ri(Z), s'écrit :

$$Ri(Z) = \{X[Zexp(-j2\pi(\ell iKi/N))]$$

$$[\sum_{K=\ell iKi}^{\ell iKi+\ell i-1} H[Zexp(-j(4\ell iKi+2K+1)(\pi/2N))]exp(-j\varphi_K)+$$

$$\sum_{K=\ell iKi}^{\ell iKi+\ell i-1} H[Zexp(-j(4\ell iKi-2K-1)(\pi/2N))]exp(j\varphi_K) +$$

$$X[Zexp(+j2\pi(\ell iKi/N))]].$$

$$[\sum_{K=\ell iKi}^{\ell iKi+\ell i-1} H[Zexp(j(4\ell iKi-2K-1)(\pi/2N))]exp(-j\varphi_K)+$$

$$\sum_{K=\ell iKi}^{\ell iKi+\ell i-1} H[Zexp(j(4\ell iKi+2K+1)(\pi/2N))]exp(j\varphi_K)] +$$

$$X[Zexp(-j2\pi(\ell i(Ki+1)/N)].$$

$$[\sum_{K=\ell iKi}^{\ell iKi+\ell i-1}$$

$$H[Zexp(-j(4\ell i(Ki+1)+2K+1)(\pi/2N))]exp(-j\varphi_K) +$$

$$\sum_{K=\ell iKi}^{\ell iKi+\ell i-1}$$

$$H[Zexp(-j(4\ell i(Ki+1)-2K-1)(\pi/2N))]exp(j\varphi_K)] +$$

$$X [Zexp(j2\pi(\ell i(Ki+1)/N))][\sum_{K=\ell iKi}^{\ell iKi+\ell i-1}$$

$$H[Zexp(-j(4\ell i(Ki+1)-2K-1)(\pi/2N))]exp(-j\varphi k) +$$

$$\sum_{K=\ell iKi}^{\ell iKi+\ell i-1}$$

$$H[Zexp(+j(4\ell i(Ki+1)+2K+1)(\pi/2N))]exp(j\varphi k)\} +$$

$$.[\sum_{K=\ell iKi}^{\ell iKi+\ell i-1} H[Zexp(-j(2K+1)\pi/2N))]exp(-j\varphi'_K) +$$

$$\sum_{K=\ell iKi}^{\ell iKi+1} H[Zexp(j(2K+1)(\pi/2N))]exp(-j\varphi_K)\} \quad 1/N \quad (8)$$

Etant donné que le filtre H vérifie la condition de quadrature (6), on a :

$$H(Zexp^{ja\pi/2N}.H(Zexp^{jb\pi/2N}) = 0 \text{ si } |a-b| \geq 4 \quad (9)$$

ce qui introduit de nombreuses simplifications dans (8).

Finalement il vient, en abandonnant le facteur 1/N :

$$Ri(Z) = X[Zexp(-j2\pi(\ell iKi/N))]H[Zexp(-j(2\ell iKi-1)(\pi/2N))].$$
$$H[Zexp(-j(2\ell iKi + 1)(\pi/2N))]exp(+j[\phi_{\ell iKi}-\phi'_{\ell iKi}]) + X[Zexp(j2\pi(\ell iKi/N))]H[Zexp(j(2\ell iKi-1)(\pi/2N))].$$

8

H[Zexp( + j(2ℓiKi + 1)($\pi$/2N)]exp(-j[$\phi_{\ell iKi}$-$\phi'_{\ell iKi}$]) + X[Zexp(-j2$\pi$(ℓi(Ki + 1)/N))].
H[Zexp(-j(2ℓi(Ki + 1)-1)($\pi$/2N))].
H[Zexp(-j(2ℓi(Ki + 1) + 1)($\pi$/2N))].
exp(j[$\phi_{\ell i(Ki+1)-1}$-$\phi'_{\ell i(Ki+1)-1}$]) + X[Zexp(j2$\pi$(ℓi(Ki + 1)/N))] H[Zexp(j(2ℓi(Ki + 1)-1)($\pi$/2N))].
H[Zexp(j(2ℓi(Ki + 1) + 1)($\pi$/2N))] exp(j[$\phi_{\ell i(Ki+1)-1}$-$\phi'_{\ell i(Ki+1)-1}$])    (10)

Pour simplifier les expressions (10) on posera :
t = ℓiKi (numéro du premier filtre composant Gi) et
v-1 = ℓiKi + ℓi-1 (numéro du dernier filtre composant Gi).
Alors (10) s'écrit :

Ri(Z) = X[Zexp(-j2$\pi$(t/N))]H[Zexp(-j(2t-1)($\pi$/2N))].
H[Zexp(-j(2t + 1)($\pi$/2N))]exp(j[$\phi$t-$\phi'$t]) + X[Zexp(j2$\pi$(t/N))]H[Zexp(j(2t-1)($\pi$/2N))].
H[Zexp( + j(2t + 1)($\pi$/2N))]exp(-j[$\phi$t-$\phi'$t]) + X[Zexp(-j2$\pi$(v/N))]H[Zexp(-j(2v-1)($\pi$/2N))].
H[Zexp(-j(2v + 1)($\pi$/2N))]exp(j[$\phi_{v-1}$-$\phi'_{v-1}$]) + X[Zexp(j2$\pi$(v/N))]H[Zexp(j(2v-1)($\pi$/2N))].
H[Zexp( + j(2v + 1)($\pi$/2N))]exp(-j[$\phi_{v-1}$-$\phi'_{v-1}$])    (11)

(i + 1)ème BRANCHE

Pour la branche (i + 1), le terme $R_{i+1}$(Z) se déduit de Ri donné par la formule (11) et s'écrit :

$R_{i+1}$(Z) = X[Zexp(-j2$\pi$(v/N))]H[Zexp(-j(2v-1)($\pi$/2N))].
H[Zexp(-j(2v + 1)($\pi$/2N))]exp(j[$\phi$v-$\phi'$v]) + X[Zexp( + j2$\pi$(v/N))]H[Zexp(j(2v-1)($\pi$/2N))].
H[Zexp([j(2v + 1)($\pi$/2N))]exp(-j[$\phi$v-$\phi'$v]) + X[Zexp(-j2$\pi$(w/N))]H[Zexp(-j(2w-1)($\pi$/2N))]
H[Zexp(-j(2w + 1)($\pi$/2N))]exp[j($\phi_{w-1}$-$\phi'_{w-1}$)]  +  X[Zexp(j2$\pi$(w/N))]H[Zexp(j(2w-1)($\pi$/2N))]  H[Zexp(j(2w + 1)-($\pi$/2N))]exp(-j[$\phi_{w-1}$-$\phi'_{w-1}$])    (12)

en désignant par w-1 le numéro du dernier filtre composant ($G_{i+1}$).

ENSEMBLE DES BRANCHES

La sortie $\hat{X}$(Z) du banc d'analyse-synthèse est donnée par :

$$\hat{X}(Z) = \sum_{i=0}^{M-1} Ui(Z) \qquad (13)$$

dans laquelle le terme de repliement peut s'écrire, à partir de ceux dûs à l'ensemble des M branches :

$$R(Z) = \sum_{i=0}^{M-1} Ri(Z)$$

Les équations (11) et (12) montrent qu'on peut dans R(Z) affecter un facteur à chaque terme en X ; par exemple pour X[Zexp(-j2$\pi$(v/N))] le facteur sera :

H[Zexp(-j(2V + 1)($\pi$/2N))]H[Zexp(-j(2v-1))].
[exp( + j[$\phi_{v-1}$-$\phi'_{v-1}$]) + exp( + j[$\phi$v-$\phi'$v])]

Si la condition sur le choix des phases donné par les équations (3), (4) est respectée, le terme exp(j-[$\phi_{v-1}$-$\phi'_{v-1}$]) + exp(j[$\phi$v-$\phi'$v]) est nul ; étant donné que le même résultat est atteint pour tous les couples de branches, tous les termes de R(Z) sont nuls et R(Z) = 0.

En conséquence, on peut considérer que Ui(Z) se réduit au premier terme de l'équation (7) et l'équation (13) devient :

$$\hat{X}(Z) = \sum_{i=0}^{M-1} (\ell i/N).X(Z).Gi(Z).G'i(Z) \qquad (14)$$

Dans la somme, le terme $\ell iGi(Z)G'i(Z)$ peut s'écrire :

$$\ell iGi(Z)G'i(Z) = [\sum_{K=\ell iKi}^{\ell iKi+\ell i-1} H_K(Z)] [\sum_{K=\ell iKi}^{\ell iKi+\ell i-1} H'_K(Z)]$$

$$= \sum_{p=0}^{\ell i-1} H_{\ell iKi+p}(Z) . H'_{\ell iKi+p}(Z) +$$

$$\sum_{p=0}^{\ell i-2} [(H_{\ell iKi+p}(Z) . H'_{\ell iKi+p+1}(Z) + H'_{\ell iKi+p}(Z) H_{\ell iKi+p+1}(Z)] \quad (15)$$

Les autres termes sont nuls dans la mesure où les filtres qui ne sont pas adjacents n'ont aucun recouvrement.

Nous allons calculer les deux termes de l'équation (15)

Calcul du premier terme :

$$\sum_{p=0}^{\ell i-1} H_{\ell i K i+p}(Z) \cdot H'_{\ell i K i+p}(Z) =$$

$$\sum_{p=0}^{\ell i-1} \left\{ [H[Z\exp(-j(\pi/2N)(2(\ell i K i+p)+1))]\exp(-j\varphi_{\ell i K i+p}) + \right.$$

$$H[Z\exp[j(\pi/2N)(2(\ell i K i+p)+1))]\exp(+j\varphi_{\ell i K i+p})].$$
$$[H[Z\exp(-j(\pi/2N)(2(\ell i K i+p)+1))]\exp(-j\varphi'_{\ell i K i+p}) +$$
$$\left. H[Z\exp(j(\pi/2N)(2(\ell i K i+p)+1))]\exp(j\varphi'_{\ell i K i+p})] \right\}$$

Compte tenu de la condition (9), il vient :

$$\sum_{p=0}^{\ell i-1} H_{\ell i K i+p}(Z) \cdot H'_{\ell i K i+p}(Z) =$$

$$\sum_{p=0}^{\ell i-1}$$

$$H^2[Z\exp(-j(\pi/2N)(2(\ell i K i+p)+1)]\exp(-j[\varphi_{\ell i K i+p}+\varphi'_{\ell i K i+p}])]$$

$$+ \sum_{p=0}^{\ell i-1} H^2[Z\exp(j(\pi/2N)(2(\ell i K i+p)+1))]$$

$$\exp(j[\varphi_{\ell i K i+p}+\varphi'_{\ell i K i+p}]) \tag{16}$$

Compte tenu de (3) et (4) : $\phi_{\ell i K i+p}+\phi'_{\ell i K i+p} = 2c_{\ell i K i+p}$ et (16) devient :

$$\sum_{p=0}^{\ell i-1} H_{\ell i K i+p}(Z) \cdot H'_{\ell i K i+p}(Z) =$$

$$\sum_{p=0}^{\ell i-1} [H^2[Z\exp([-j(\pi/2N)(2(\ell i K i+p-1))]\exp(-j2c_{\ell i K i+p} +$$
$$H^2[Z\exp(+j(\pi/2N)(2(\ell i K i+p-1))]\exp(+j2c_{\ell i K i+p})] \tag{17}$$

Calcul du deuxième terme

Un calcul similaire au précédent tenant compte de ce que des produits sont nuls du fait de la condition (9), montre que :

$$\sum_{p=0}^{\ell i-2} [H_{\ell iKi+p}(Z) . H'_{\ell iKi+p+1}(Z) + H'_{\ell iKi+p}(Z) . H_{\ell iKi+p+1}(Z) ] =$$

$$\sum_{p=0}^{\ell iKi-2} [H[Zexp(-j(\pi/2N)(2\ell iki+2p+1))].$$

$$H[Zexp(-j(\pi/2N)(2\ell iKi+2p+3))] .$$

$$[exp(-j[\varphi_{\ell iKi+p}+\varphi'_{\ell iKi+p+1}]) + exp(-j[\varphi'_{\ell iKi+p}+\varphi_{\ell iKi+p+1}])]]$$

$$+ \sum_{p=0}^{\ell iKi-2} [H(Zexp(-j(\pi/2N)(2\ell iki+2p+1))]$$

$$H[Zexp(-j(\pi/2N)(2\ell iKi+2p+3))].$$

$$[exp(+j[\varphi_{\ell iKi+p}+\varphi'_{\ell iKi+p+1}]) + exp(+j[\varphi'_{\ell iKi+p}+\varphi_{\ell iKi+p+1}])]] \qquad (18)$$

Les phases $\phi$ et $\phi'$ qui interviennent dans (18) sont liées par $\phi_{\ell iKi+p} + \phi'_{\ell iKi+p+1} = \pi/2 + c_{\ell iKi+p} + c_{\ell iKi+p+1}$ et $\phi'_{\ell iKi+p} + \phi_{\ell iKi+p+1} = -\pi/2 + c_{\ell iKi+p} + c_{\ell iKi+p+1}$, ce qui fait apparaître que les sommes d'exponentielles en $\phi$ et $\phi'$ sont nulles. Par conséquent, l'expression (18) est nulle.

L'ensemble des deux termes de l'expression (15) se réduit donc à :

$$\ell iGi(Z).Gi'(Z) =$$

$$\sum_{p=0}^{\ell i-1} \left\{ H^2[Zexp([-j(\pi/2N)(2(\ell iKi+p)+1))]exp(-j2c_{\ell iKi=p}) + H^2[Zexp(j(\pi/2N)(2(\ell iKi+p)+1))]exp(j2c_{\ell iKi=p})] = \right.$$

$$\sum_{p=\ell iKi}^{\ell iKi+\ell i-1} H^2(Zexp([-j(\pi/2N)(2p+1))]exp(-j2c_p) + H^2[Zexp(j(\pi/2N)(2p+1))]exp[j2c_p] \right\} \qquad (19)$$

La sortie $\hat{X}(Z)$ donnée par l'équation (14) fait intervenir une sommation pour M valeurs de i de 0 à M-1 et p couvre toutes les valeurs entières de 0 à N-1 puisque tous les filtres des bancs ($H_K$) et ($H'_K$) sont utilisés.

L'équation (14) devient donc :

$$\hat{X}(Z) = \frac{1}{N} \sum_{p=0}^{N-1} \left\{ H^2[Zexp(-j(\pi/2N)(2p+1))]exp(-j2c_p) + H^2[Zexp([j(\pi/2N)(2p+1))]exp([j2c_p) \right\} .X(Z) \qquad (20)$$

L'invention est susceptible d'être mise en oeuvre quelle que soit la méthode utilisée pour générer les bancs initiaux de filtres ($H_K$) et ($H'_K$).

Un premier cas correspond au mode de génération de bancs initiaux de filtres à partir d'un filtre prototype par le processus décrit dans l'article de Nussbaumer et autre déjà mentionné ; un autre correspond à l'enseignement de l'article "codeur de parole utilisant des bancs de filtres efficaces et des quantificateurs vectoriels" de J.Masson et autre, 10ème colloque sur le traitement du signal et de ses applications, Nice 1985.

Dans le premier cas, les filtres sont générés à partir du prototype en adoptant

$c_K = 0$ et $N_F = 2pN + 1$

Dans ce cas :

$$\hat{X}(\omega) = (1/N) \exp[-j2pN\omega] \quad \left\{ \sum_{K=0}^{N-1} h^2 [\omega - (2K+1)\pi/2N] \right.$$

$$\left. + h^2 [\omega + (2K+1)\pi/2N] \right\} (-1)^P X(\omega)$$

Les équations (5) et (6) montrent que :

$$\sum_{K=0}^{N-1} h^2 [\omega - (2K+1)\pi/2N] + h^2 [\omega + (2K+1)(\pi/2N)] = 1$$

et

$\hat{X}(\omega) = \frac{1}{N} \exp(-j2pN\omega] (-1)^P . X(\omega)$, soit :

$$\hat{x}(n) = [(-1)^P/N)] x(n-2pN).$$

On voit qu'on récupère le signal initial x à une constante et un retard près.

Dans le second cas, où le mode de génération est celui de l'article J.MASSON et autre, on a :

$c_K = (NF-1)(2K+1)\pi/4N$.

NF peut être quelconque. Dans ce cas :

$$\hat{X}(\omega) = (1/N) \exp[-j(NF-1)\omega]$$

$$\left\{ \sum_{K=0}^{N-1} h^2 [\omega - (2K+1)\pi/2N] + h^2 [\omega + (2K+1)\pi/2N)] \right\} X(\omega)$$

ce qui donne, compte tenu encore de (5) et (6) :

$\hat{X}(\omega) = (1/N) \exp[-j(NF-1)\omega] . X(\omega)$, soit
$\hat{x}(n) = (1/N) x(n-NF-1)$.

On récupère encore le signal initial à une constante et un retard près.

Donc, quel que soit le mode utilisé pour générer les deux bancs de filtres $(H_K)$ et $(H'_K)$, les deux bancs $(Gi)$ et $(G'i)$ permettent une analyse-synthèse d'un signal en M sous-bandes d'inégales largeurs où le signal reconstitué x est la réplique du signal initial x à une constante et un retard près.

Ÿ On donnera maintenant un mode particulier de mise en oeuvre de l'invention faisant apparaître comment on peut implanter de façon efficace les bancs $(Gi)$ et $(G'i)$, définis à partir des deux bancs $(H_K)$ et $(H'_K)$ de filtres d'égales largeurs, à l'aide d'un réseau polyphasé associé au filtre prototype H et de deux transformées en cosinus impaires.

On désignera par Nm = Inf (Ni, i = 0, ..., M-1) le plus petit facteur de sous-échantillonnage du banc Gi . La mise en oeuvre de l'invention impose que les autres facteurs de sous-échantillonnage du banc (Gi) vérifient la condition :

$$Ni = Nm.mi \quad avec \quad mi \in \mathbb{N}$$

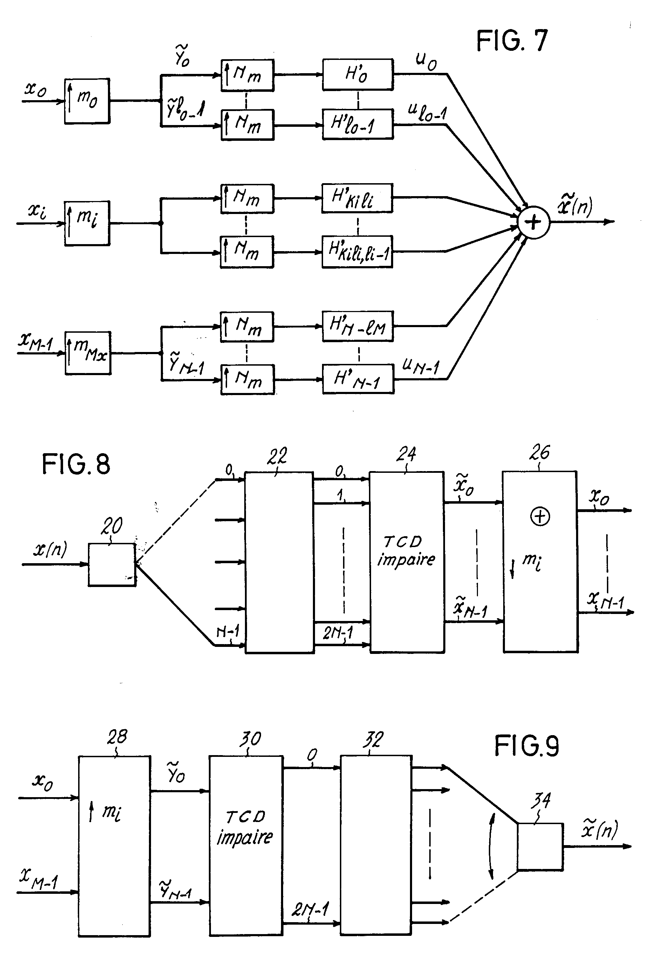

Si cette condition est remplie, l'analyse et la synthèse du signal en M sous-bandes d'inégales largeurs peuvent se faire comme indiqué sur les figures 6 et 7, respectivement.

Donc deux conditions devront être remplies par les facteurs de sous-échantillonnage Ni du banc :

$$\forall i \quad \in [0, M-1], \quad \exists \ell i \in \mathbb{N} \mid N = \ell i . Ni$$

$$\forall i \quad \in [0, M-1], \quad \exists mi \in \mathbb{N} \mid N_i = mi . Nm,$$

avec Nm = Inf {Ni, i = 0,..., M-1}

La première condition permet de regrouper $\ell i$ filtres adjacents des bancs initiaux $(H_K)$ et $(H'_K)$ pour former les filtres des bancs (Gi) et (G'i).

La deuxième condition permet de faire tous les calculs, à l'analyse et à la synthèse, à une même fréquence pour toutes les sous-bandes et se traduit par une simplification des moyens nécessaires.

Il semble à première vue que les deux conditions ci-dessus soient restrictives. Dans la pratique elles ne représentent pas une contrainte gènante, car elles laissent subsister de très nombreuses possibilités de découpe en fréquence, par exemple :

1) Pour un filtre prototype H : [0, $\pi/8$]

Bancs de 4 filtres d'égale largeur :
{$H_0$, $H_1$, $H_2$, $H_3$} ,
{$H'_0$, $H'_1$, $H'_2$, $H'_3$} ,
Bancs de 3 filtres d'inégales largeurs :

$$\left\{ H_0, \ H_1, \ \frac{H_2 + H_3}{2} \right\} \ ,$$

{H'$_0$, H'$_1$, H'$_2$, H'$_3$}

2) Pour un filtre prototype H : [0, $\pi/12$]

Bancs de 6 filtres d'égale largeur :
{$H_0$, $H_1$, $H_2$, $H_3$, $H_4$, $H_5$} ,
{$H'_0$, $H'_1$, $H'_2$, $H'_3$, $H'_4$, $H'_5$} ,
bancs de 4 filtres d'inégales largeurs :

$$\left\{ H_0, \ H_1, \ \frac{H_2 + H_3}{2}, \ \frac{H_4 + H_5}{2} , \right\}$$

{H'$_0$, H'$_1$, H'$_2$ + H'$_3$ , H'$_4$ + H'$_5$}

3) Pour un filtre prototype H : [0, $\pi/16$]

Bancs de 8 filtres d'égale largeur :
$\{H_0, H_1, H_2, H_3, H_4, H_5, H_6, H_7\}$
$\{H'_0, H'_1, H'_2, H'_3, H'_4, H'_5, H'_6, H'_7\}$
Bancs de 4 filtres d'inégales largeurs :

$$\left\{H_0, \; H_1, \; \frac{H_2 + H_3}{2}, \; \frac{H_4 + H_5 + H_6 + H_7}{4}\right\} \; ,$$

$\{H'_0, H'_1, H'_2 + H'_3, H'_4 + H'_5 + H'_6 + H'_7\}$

ANALYSE

Sur la figure 6, qui montre le banc de filtres d'analyse à l'émission, on voit qu'on peut écrire, pour K = 0,....,N-1,

$$\tilde{x}_K (m.N_m) = \sum_{n=0}^{NF-1} h_K(n) x(mN_m - n)$$

où $h_K$ est la réponse impulsionnelle du filtre $H_K$ c'est à dire :

$$h_K(n) = 2 \cos [2\pi/8N (2K+1)(2n-c_a-N)]. h(n) \qquad (21)$$

avec $c_a = 0$ ou $c_a = (NF-1)$
L'équation (21) découle directement des équations (1) et (3).
On peut toujours choisir $N_F$ pour avoir $N_F = 2pN$ avec $p \in \mathbb{N}$ , quitte à compléter la réponse impulsionnelle du filtre prototype avec des valeurs nulles.
Dans ce cas :

$$\tilde{x}_K (mN_m) = \sum_{n=0}^{NF-1} h(n).2\cos[(2\pi/8N)(2K+1)(2n-c_a-N)].x(mNm-n)$$

On peut poser $n = rNm + p$ avec
$r = 0, ...,2\ell p-1, \; \ell = N/_{Nm}$
$p = 0,..., Nm-1$
alors :

$$\tilde{x}_K(mNm) = \sum_{r=0}^{2\ell p-1} \left\{ \sum_{p=0}^{Nm-1} 2h(rNm+p) \right.$$

$$\cos[(2\pi/8N)(2K+1)(2rNm+2p-c_a-N)].x(mNm-rNm+p) \left.\right\} \qquad (22)$$

on peut alors décomposer r sous la forme :
$r = 2a\ell + b$ avec
$a = 0,..., p-1$

b = 0,...,2ℓ-1

et la relation (22) devient :

$$\tilde{x}_K(mNm) = \sum_{p=0}^{Nm-1} \left\{ \sum_{b=0}^{2\ell-1} \left[ \sum_{a=0}^{p-1} (-1)^a . h(2aN+bNm+p) . \right. \right.$$
$$x(mNm-2aN-bNm-p)] .$$
$$\left. \left. 2\cos\ (2\pi/8N)(2K+1)(2bNm+2p-c_a-N)] \right\} \right. \tag{23}$$

On désignera par :

$h_p\ (r) = h\ (2N + p)$

la réponse du réseau polyphasé associé à H, et par

$c_{K,p} = \cos\ [2\pi/8N\ (2K + 1)\ (2p-c_A-N)].2$

une fonction transformée en cosinus impaire et on posera :

$x_p\ (r) = x\ (r\ Nm-p)$

La relation (23) devient alors :

$$\tilde{x}_K(m\ Nm) = \sum_{p=0}^{Nm-1} \left\{ \sum_{b=0}^{2\ell-1} \sum_{a=0}^{p-1} (-1)^a . h_{bNm+p}(2a) x_{bNm+p}(m-2a)] \right.$$
$$\left. c_{K,bNm+p} \right\} \tag{24}$$

Sous cette forme, l'équation fait apparaître que les N signaux $\tilde{x}_K$ à la fréquence fe/Nm peuvent être obtenus à l'aide

- d'un réseau polyphasé, suivi
- d'une transformée en cosinus impaire à 2N dimensions.

Les M sorties en sous-bandes d'inégales largeurs sont alors obtenues en effectuant une sommation partielle et un nouveau sous-échantillonnage des N signaux $\tilde{x}_K$.

La figure 8 montre la constitution de principe de la partie "émission" du système.

Le signal entrant x(n) est soumis à échantillonnage en 20 et les M signaux échantillonnés sont appliqués au réseau polyphasé 22 qui peut avoir une constitution connue. Les 2N signaux sortant du réseau polyphasé sont appliqués au circuit de transformée en cosinus impaire 24 et les signaux de sortie $\tilde{x}_0$..., $\tilde{x}_{N-1}$, sont appliqués au circuit de sommation et de sous-échantillonage 26.

SYNTHESE __ (Figure 9)

A la réception, les M signaux $x_0$, ...$x_{M-1}$ en sous-bandes reçus sont transformés en N signaux à la fréquence fe/Nm. Pour cela, il y a d'abord sur-échantillonnage en 28 en insérant ($m_i$-1) valeurs nulles (ou "zéros") pour chaque signal de sous-bande d'indice i et en séparant celui-ci en ℓi signaux égaux.

On peut alors montrer, en posant :

$c'_{K,p} = 2\ \cos\ [(2\pi/8N)\ (2K + 1)(2p-c_A + N)]$

16

que la sortie $\hat{x}$ du banc de synthèse est donnée par :

$$\hat{x}(mNm+p) = \sum_{b=0}^{2\ell-1} \left\{ \sum_{a=0}^{p-1} (-1)^a h_{bNm+p}(2a) \right.$$

$$\left. \left[ \sum_{K=0}^{N-1} \tilde{Y}_K(m-2a\ell-b) C'_{K,bNm+p} \right] \right\} \quad \text{pour } p=0,..,Nm-1$$

$$(25)$$

Les signaux $\tilde{y}$ sont appliqués à une transformée en cosinus impaire 30 de dimension 2N, puis à un réseau polyphasé 33 correspondant au filtre H, avant sommation en 34.

Exemple

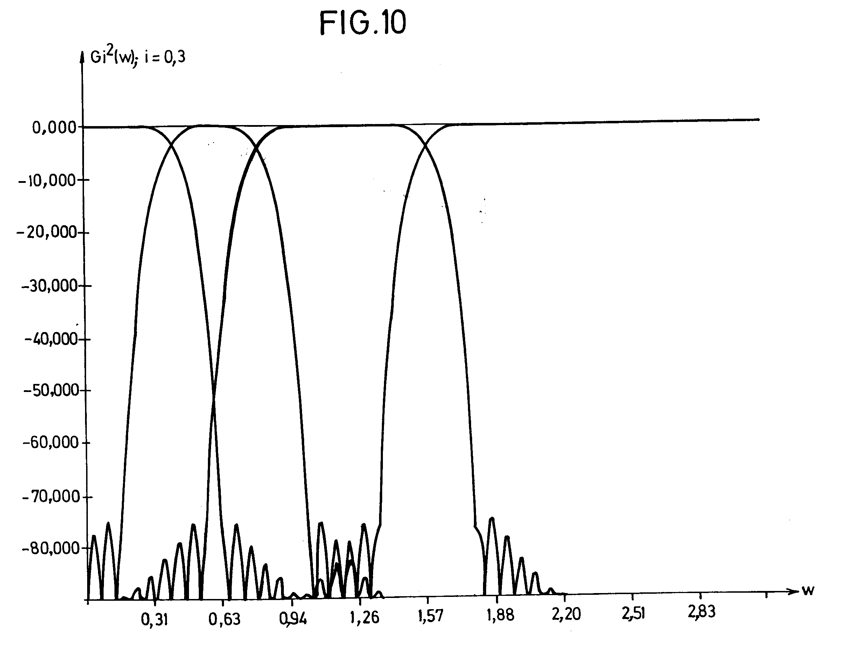

On decrira maintenant, en faisant référence aux figures 10 à 19, un système d'analyse-synthèse applicable à la transmission d'une voie son de haute qualité, exigeant une bande passante [0, 15 KHz), avec une fréquence d'échantillonnage fe = 32 KHz.

A l'émission, le banc de filtres d'analyse peut comporter quatre filtres d'inégales longueurs, dont les réponses Gi (f) ont l'allure montrée en figure 10, constituées à partir de huit filtres d'égale largeur, dont les deux premiers ont les courbes de réponse en fréquence montrées en figure 10, les autres courbes étant simplement décalées des premières.

Les filtres $(H_K)$ sont générés à partir d'un filtre prototype passe-bas, symétrique, à phase linéaire, ayant une bande passante [0,1 KHz] et vérifiant les conditions de quadrature (5) et (6).

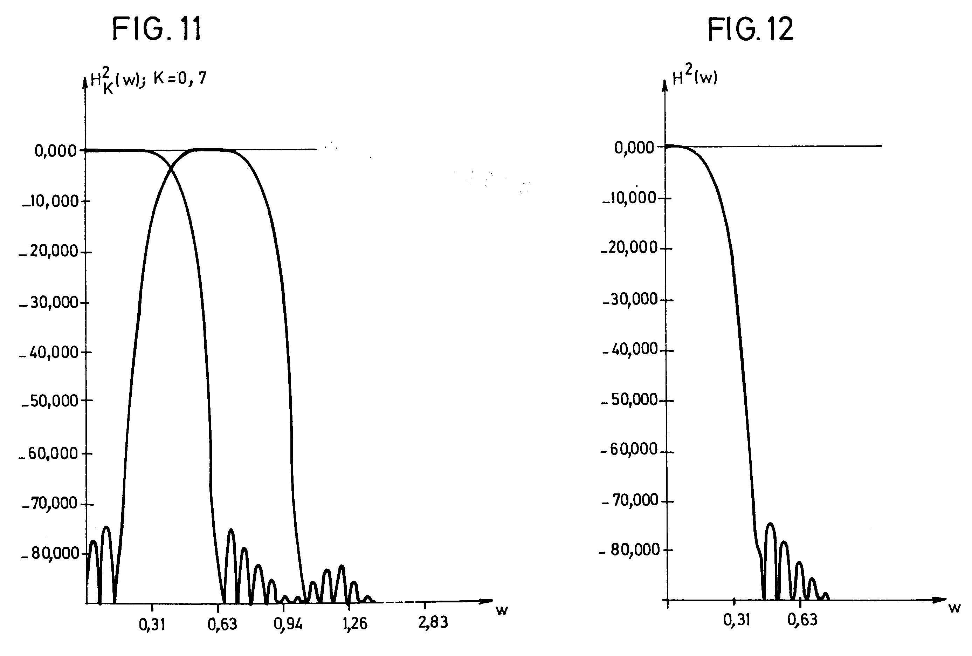

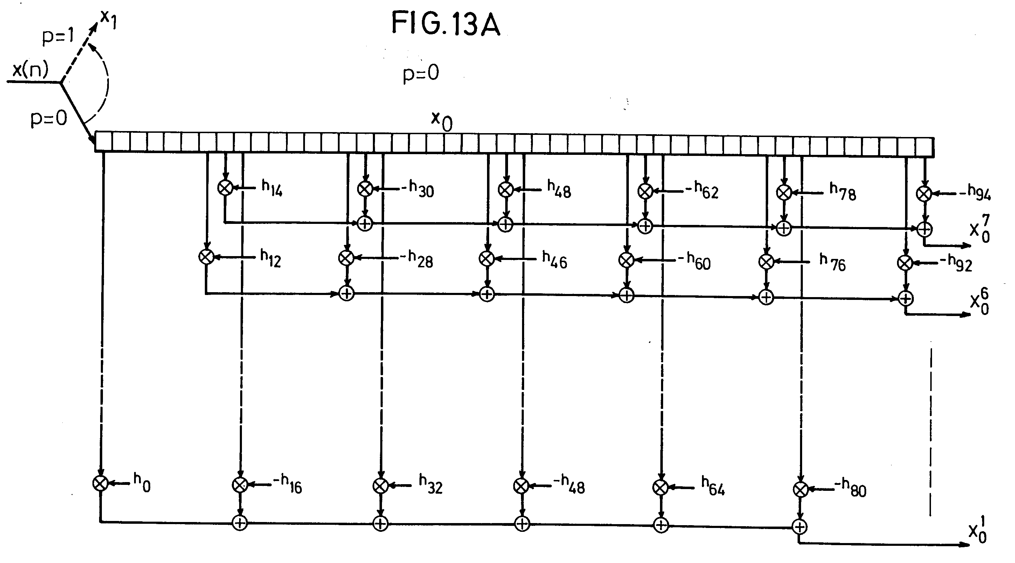

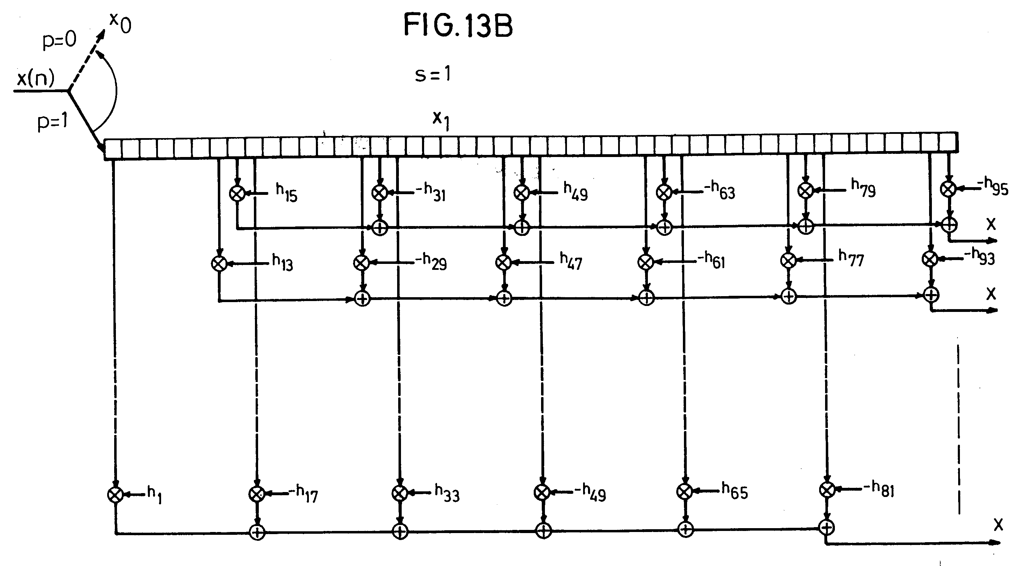

Ce filtre peut avoir une constitution classique, notamment une de celles décrites dans les documents mentionnés plus haut. Un filtre prototype à quatre vingt seize coefficients permettant d'obtenir les réponses des figures 11 et 12 a la caractéristique H (f) montrée en figure 13.

Si on désigne par h(n), avec n = 0,..., 95 les coefficients du filtre prototype, les coefficients des filtres du banc $(H_K)$ sont :

$$H_K(n) = 2h(n). \cos [(2\pi/64)(2K + 1)(2n-103)]$$

avec K = 0,7 et n = 0,95
Pour le banc de synthèse constitué à partir du même filtre prototype, on aura:

$$h'_K(n) = 2h(n).\cos [(2\pi/64)(2K + 1)(2n-87)]$$

avec K = 0,7 et n = 0,95
Les coefficients des deux bancs d'inégale largeur se déduisent de ceux des filtres $(H_K)$ et $(H'_K)$ :
Pour (Gi)

$$g_0(n) = h_0(n)$$
$$g_1(n) = h_1(n)$$
$$g_2(n) = 1/2[h_2(n) + h_3(n)]$$
$$g_3(n) = 1/4[h_4(n) + h_5(n) + h_6(n) + h_7(n)]$$

avec n = 0,..95
Pour (G'i)

$$g'_0(n) = h'_0(n)$$
$$g'_1(n) = h'_1(n)$$
$$g'_2(n) = h'_2(n) + h'_3(n)$$
$$g'_3(n) = h'_4(n) + h'_5(n) + h'_6(n) + h'_7(n)$$

avec n = 0,..95
Le signal de sortie du banc de filtres de synthèse est obtenu en reportant les valeurs numériques dans l'équation (25) qui devient :

$$x(2m+p) = \sum_{b=0}^{7} \left\{ \sum_{a=0}^{5} (-1)^a h_{2b+p}(2a) \right.$$

$$\left. [ \sum_{K=0}^{7} \tilde{Y}_K(m-8a-b)\, C'_{K,2b+p} ] \right\}$$

où

$$C'_{K,2b+p} = 2 \cos[(2\pi/64)(2K+1)(4b+2p-87)]$$

$p = 0,1$

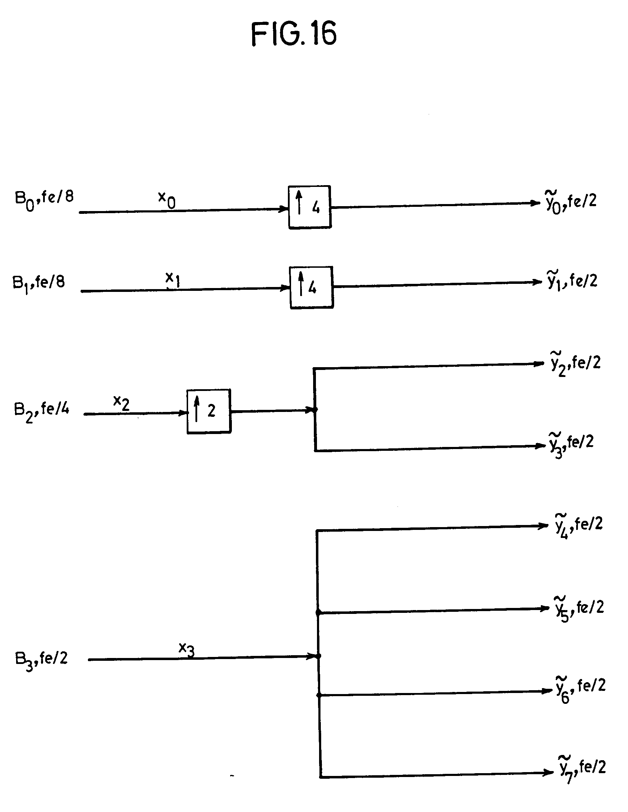

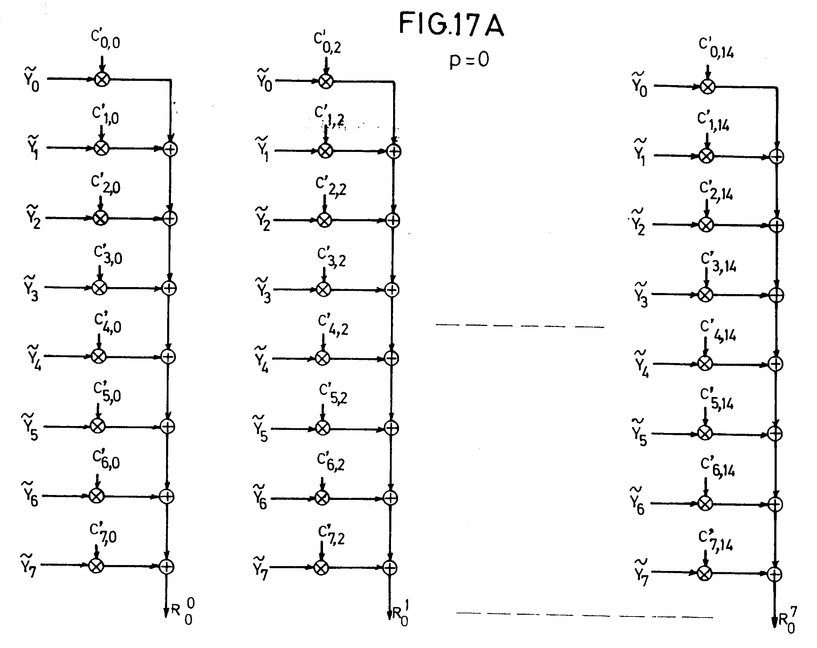

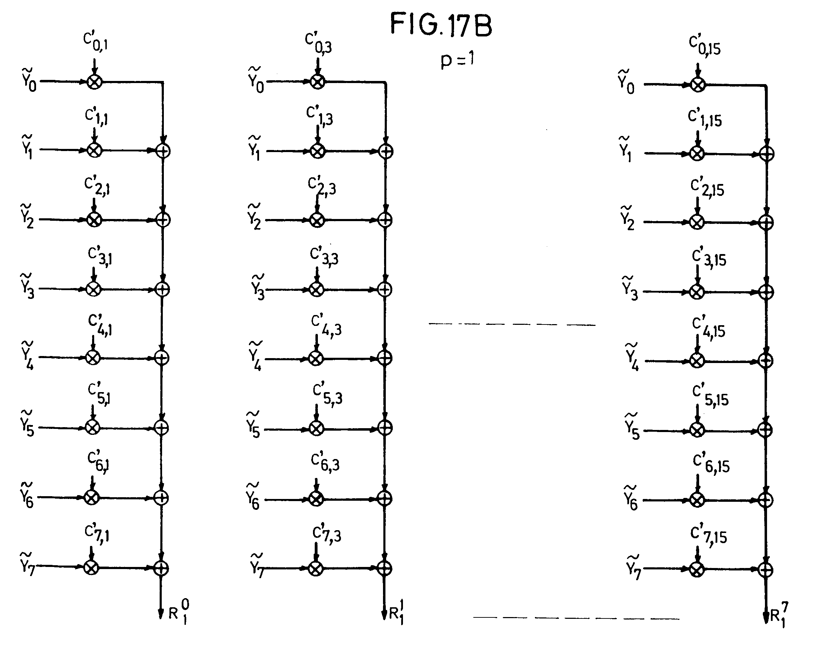

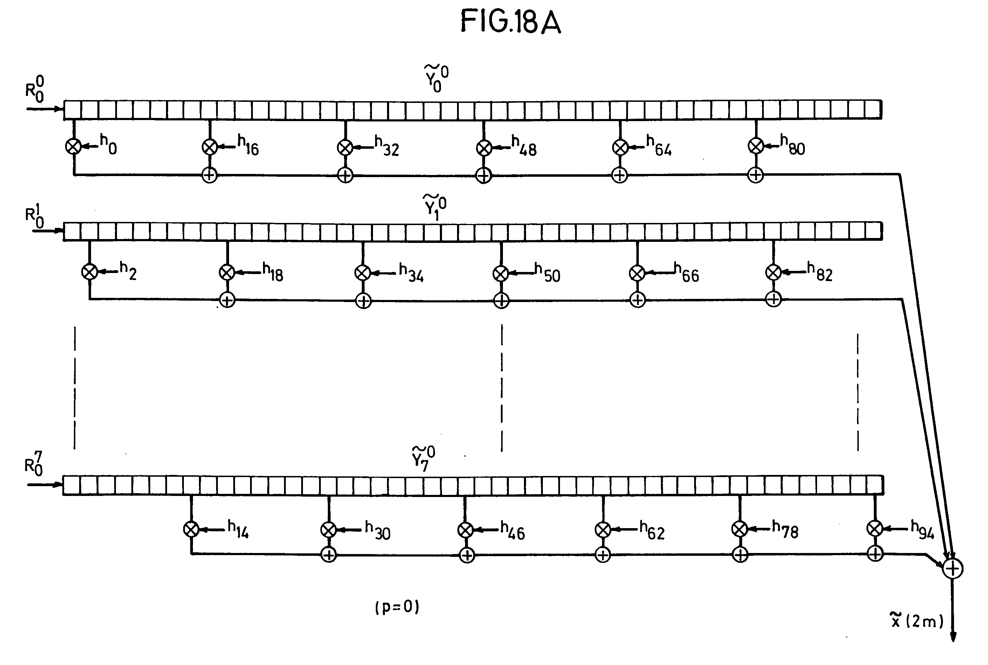

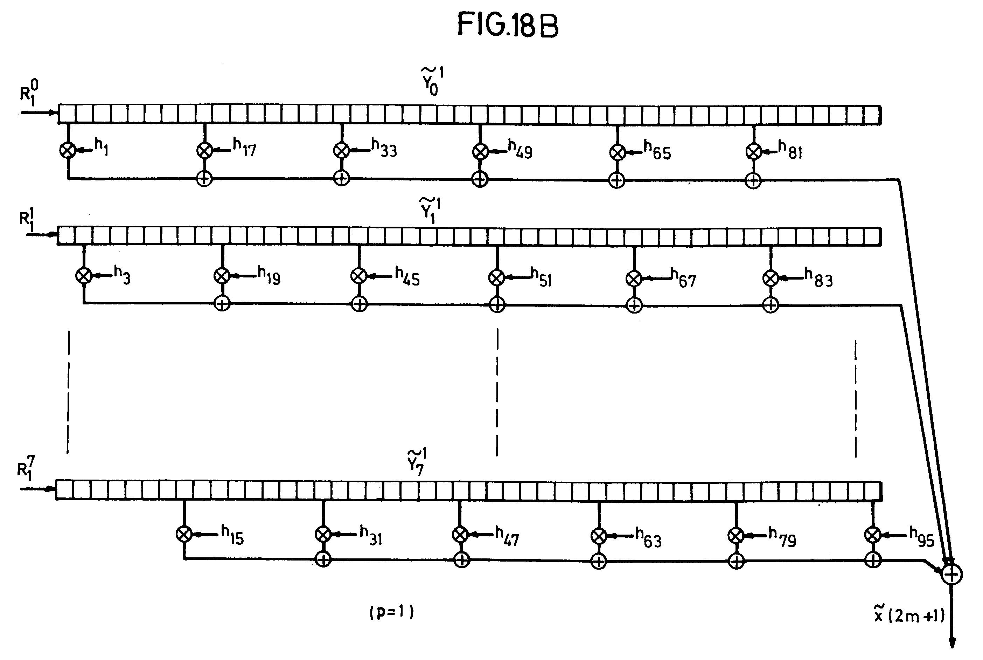

Les figures 16 à 18B peuvent être regardées comme symétriques des figures 13A à 15. La figure 16 représente l'obtention des 8 signaux $\tilde{y}_K$ à la fréquence 16 KHz à partir des huit signaux transmis. Les figures 17A et 17B représentent l'action de la transformée en cosinus impaire $C'_{K,2b+p}$ sur ces huit signaux, pour les valeurs $p=0$ et $p=1$ respectivement. Et les figures 18A et 18B montrent schématiquement la reconstitution du signal x $(2m+p)$ à partir du réseau polyphasé associé à H, pour $p=0$ et $p=1$ respectivement

Si on revient maintenant à l'analyse, on voit que la fréquence maximale est obtenue pour la quatrième sous-bande. Elle est égale à fe/2 = 16 KHz. Les huit signaux en sous-bandes à la fréquence de 16 KHz sont obtenus en reportant les valeurs numériques dans l'équation (24) qui devient :

$$\tilde{x}_K(2m) = \sum_{p=0}^{1} \left\{ \sum_{b=0}^{7} [\sum_{a=0}^{5} (-1)^a h_{2b+p}(2a) x_{2b+p}(m-2a)] C_{K,2b+p} \right\}$$

avec:

$C_{K,2b+p} = 2 \cos[2\pi/64(2K+1)(4b+2p-105)]$
$h_{2b+p}(2a) = h(16a+2b+p)$
$x_{2b+p}(m-2a) = x(2m-16a-2b-p)$

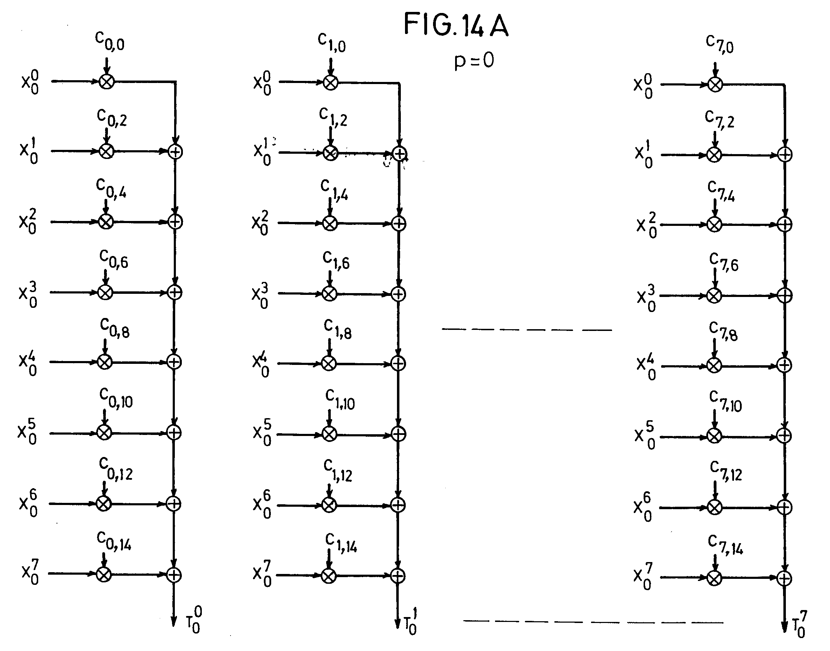

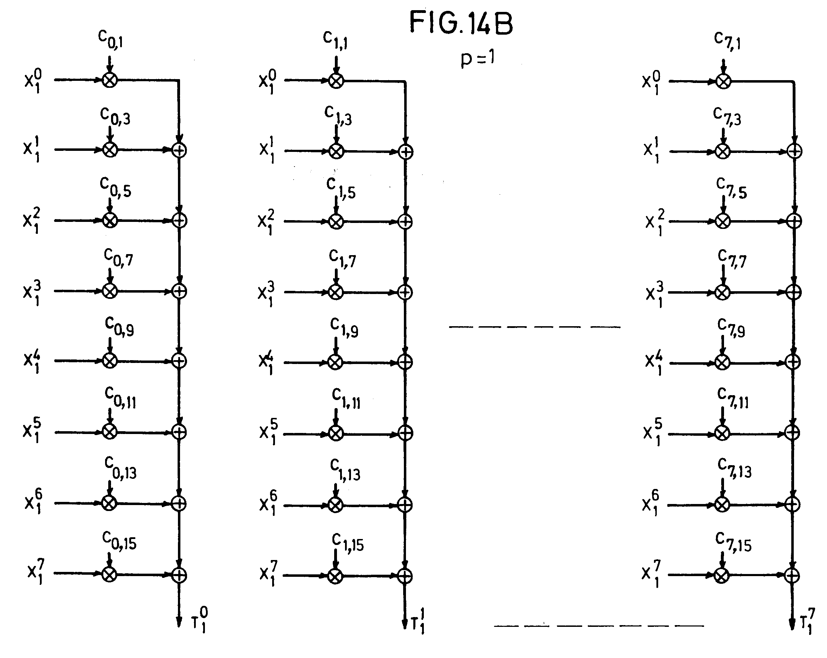

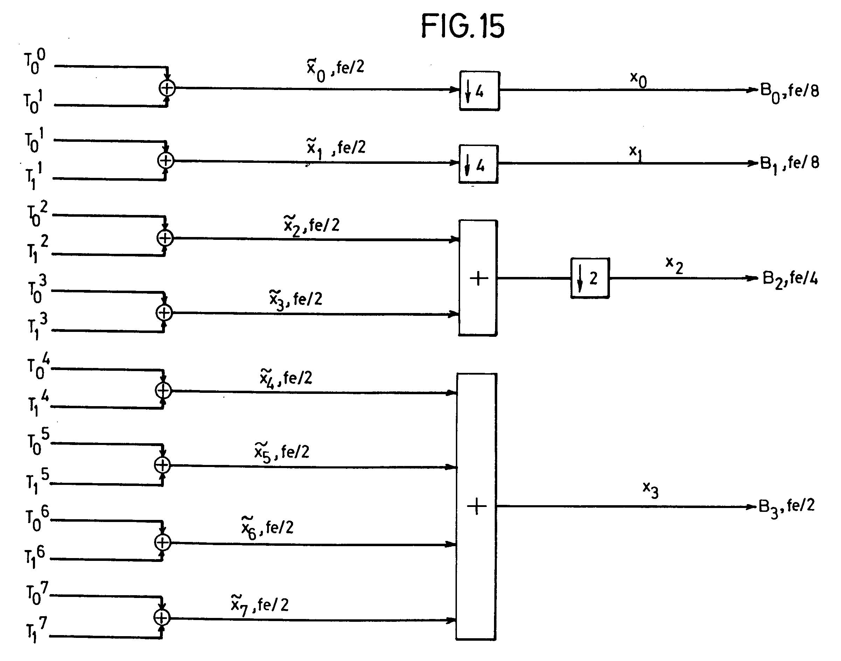

L'analyse implique successivement le filtrage par un réseau polyphasé, par l'application d'une transformée en cosinus impaire avant les sommations et sous-échantillonnages (Figure 8). Les figures 13A et 13B montrent schématiquement l'application des coefficients de filtrage h pour $p=0$ et $p=1$, respectivement. Les figures 14A et 14B montrent schématiquement l'élaboration des huit sorties $T_0^0$, $T_0^1$,...$T_0^7$ à fréquence fe/2 = 16 KHz à partir de la transformée en cosinus impaire $c_{K,2b+p}$, respectivement pour $p=0$ et $p=1$. Enfin, la figure 15 montre schématiquement l'obtention de l'ensemble des quatres sorties en sous-bandes aux fréquences 4 KHz, 4KHz, 8KHz, 16 KHz pour transmission.

On voit que le système suivant l'invention permet de s'affranchir des limitations de systèmes antérieurement connus en autorisant l'analyse et la synthèse d'un signal en sous-bandes d'inégales largeurs et ce sans exiger de filtres compensateurs ou de retard particulier.

La charge de calcul que représente la mise en oeuvre des bancs d'analyse et de synthèse est tout à fait compatible avec les processeurs de signaux actuellement disponibles : dans le cas de l'exemple particulier donné plus haut d'un signal son de haute qualité, l'analyse et la synthèse exigent seulement chacune deux microprocesseurs de traitement de signal d'un type maintenant disponible, par exemple TMS 320-20.

**Revendications**

1. Système de traitement numérique du signal, comprenant un banc de filtres d'analyse ($H_K$) permettant de décomposer un signal entrant x, occupant une bande déterminée fe/2 et échantillonné à la fréquence fe, en un nombre entier N de signaux situés dans des sous-bandes adjacentes et échantillonnés et un banc de filtres de synthèse permettant de reconstituer le signal entrant à partir desdits signaux dans les sous-bandes, lesdits bancs de filtres étant formés chacun d'un nombre N pair de filtres de même largeur réalisés chacun par modulation d'un filtre prototype passe-bas ayant une réponse impulsionnelle symétrique répondant aux conditions de quadrature dans une bande ne débordant que sur les filtres immédiatement adjacents et ayant une réponse nulle en dehors de cette bande, dans lequel les filtres ($H_K$) du banc d'analyse sont regroupés pour constituer M filtres composés (Gi) comportant des nombres ℓi de filtres ($H_K$) différents d'un filtre composé (Gi) à l'autre, les valeurs Ni = N/ℓi étant entières, le sous-échantillonnage est effectué à une fréquence distincte fe/Ni pour chaque filtre (Gi) ; et tous les filtres de même largeur sont regroupés de façon que les facteurs de sous-échantillonnage (Ni) remplissent la condition

Ni = $m_i$ . Nm

où Nm est le plus petit facteur de sous-échantillonage du banc de filtres Gi et $m_i$ est un nombre entier, pour permettre d'effectuer tous les calculs à la même fréquence, les filtres du banc de synthèse ayant une constitution symétrique.

2. Système selon la revendication 1, caractérisé en ce que le banc d'analyse comprend : un réseau polyphasé (22) à N entrées ; des moyens (24) pour effectuer sur les 2N sorties du réseau une transformée en cosinus impaire à 2N dimensions ; et des moyens (26) de nouveau sous-échantillonnage et de sommation des N sorties x desdits moyens de transformée.

3. Système selon la revendication 2, caractérisé en ce que le banc de synthèse comprend : des moyens (28) de sous-échantillonnage et de répartition des M signaux $x_0$, ..., $x_{M-1}$ provenant du banc d'analyse ; des moyens (30) pour effectuer une transformée en cosinus impaire sur les signaux $\tilde{y}_0$, ..., $\tilde{y}_{N-1}$ provenant des moyens de sous-échantillonnage ; un réseau polyphasé (32) à 2N entrées, et un sommateur (34) des sorties dudit réseau.

4. Système selon l'une quelconque des revendications précédentes, caractérisé en ce que, le filtre prototype ayant une largeur de bande [0, $\pi/8$], où $\pi$ = fe/2, et les bancs d'analyse et de synthèse comportant l'un et l'autre quatre filtres ($H_K$) ou ($H'_K$) d'égale largeur, les bancs (Gi) à l'émission et ($G'_i$) à la réception comportent chacun trois filtres, respectivement
$H_0$, $H_1$, ($H_2$ + $H_3$)/2
$H'_0$, $H'_1$, $H'_2$ + $H'_3$

5. Système selon l'une quelconque des revendications 1 à 3, caractérisé en ce que, le filtre prototype ayant une largeur de bande [0, $\pi/12$], où $\pi$ = fe/2, et les bancs d'analyse et de synthèse comportant l'un et l'autre six filtres ($H_K$) ou ($H'_K$) d'égale largeur, les bancs (Gi) à l'émission et ($G'_i$) à la réception comportent chacun quatre filtres, respectivement
$H_0$, $H_1$, ($H_2$ + $H_3$)/2, ($H_4$ + $H_5$)/2
$H'_0$, $H'_1$, $H'_2$ + $H'_3$, $H'_4$ + $H'_5$

6. Système selon l'une quelconque des revendications 1 à 3, caractérisé en ce, que le filtre prototype ayant une largeur de bande [0, $\pi/16$], où $\pi$ = fe/2 et les bancs d'analyse et de synthèse comportant l'un et l'autre huit filtres ($H_K$) ou ($H'_K$) d'égale largeur, les bancs (Gi) à l'émission et ($G'_i$) à la réception comportent chacun quatre filtres, respectivement
$H_0$, $H_1$, ($H_2$ + $H_3$)/2, ($H_4$ + $H_5$ + $H_6$ + $H_7$)/4
$H'_0$, $H'_1$, $H'_2$ + $H'_3$, $H'_4$ + $H'_5$, $H'_6$ + $H'_7$

7. Système selon la revendication 6, d'analyse-synthèse d'un signal son haute qualité échantillonné à la fréquence fe = 32 kHz, caractérisé en ce que le filtre prototype est un filtre passe-bas non récursif à phase linéaire de bande passante [0, 1 kHz] à 96 coefficients, les quatre sous-bandes étant respectivement :
0, 2kHz
2 kHz 4 kHz
4 kHz 8 kHz
8 kHz 16 kHz

**Claims**

1. System for digital processing of a signal, comprising a bank of analysis filters ($H_K$) enabling to split an input signal x, which covers a predetermined band fe/2 and is sampled at frequency fe, into a plurality N of sampled signals located in mutually adjacent sub-bands and a bank of synthesis filters enabling to recontruct the input signal from said signals in the sub-bands, said banks of filters each comprising an even number N of filters having the same width each derived by modulation of a low-pass prototype filter having a symmetrical pulse response fulfilling the quadrature conditions in a band which only overlaps the immediately adjacent filters and having a zero response outside that band, wherein the filters ($H_K$) of the analysis bank are assembled for constituting M composite filters (Gi) comprising pluralities $\hbar$ of filters ($H_K$), in the different composite filters, the values Ni = N/$\hbar$ being integers; sub-sampling is carried out at a different frequency fe/Ni for each filter (Gi); and all filters of same width are assembled for the sub-sampling factors (Ni) to fulfil the condition

   Ni = $m_i$ . Nm

   where Nm is the smallest sub-sampling factor of the bank of filters Gi and $m_i$ is an integer, for enabling all computations at the same frequency, the filters of the synthesis bank having a symmetrical construction.

2. System according to claim 1, characterized in that the analysis bank comprises: a polyphase network (22) having N inputs; means (24) for carrying out an odd cosine transform having 2N dimensions on the 2N outputs of the network; and means (26) for an additional sub-sampling and summation of the N outputs x of said transformation means.

3. System according to claim 2, characterized in that the synthesis bank comprises: means (28) for sub-sampling and distributing the M signals $x_0$, ..., $x_{M-1}$ originating from the analysis bank; means (30) for carrying out an odd cosine transform on signals $\tilde{y}_0$, ..., $\tilde{y}_{N-1}$ originating from the sub-sampling means; a polyphase network (32) having 2N inputs; and a summer (34) for summing the outputs of said network.

4. System according to any one of the preceding claims, characterized in that, the prototype filter having a band width [0, $\pi/8$], where $\pi$ = fe/2, and the analysis and synthesis banks each having four filters ($H_K$) or ($H'_K$) of same width, the banks (Gi) for transmission and (G'i) for reception each have three filters, respectively

   $H_0$, $H_1$, ($H_2$ + $H_3$)/2
   $H'_0$, $H'_1$, $H'_2$ + $H'_3$

5. System according to any one of claims 1-3, characterized in that, the prototype filter having a band width [0, $\pi/12$], where $\pi$ = fe/2, and the analysis and synthesis banks each having four filters ($H_K$) or ($H'_K$) of same width, the banks (Gi) for transmission and (G'i) for reception each have four filters, respectively:

   $H_0$, $H_1$, ($H_2$ + $H_3$)/2, ($H_4$ + $H_5$)/2
   $H'_0$, $H'_1$, $H'_2$ + $H'_3$, $H'_4$ + $H'_5$

6. System according to any one of claims 1-3, characterized in that, the prototype filter having a band width [0, $\pi/16$], where $\pi$ = fe/2, and the analysis and synthesis banks each having four filters ($H_K$) or ($H'_K$) of same width, the banks (Gi) for transmission and (G'i) for reception each have four filters, respectively:

   $H_0$, $H_1$, ($H_2$ + $H_3$)/2, ($H_4$ + $H_5$ + $H_6$ + $H_7$)/4
   $H'_0$, $H'_1$, $H'_2$ + $H'_3$, $H'_4$ + $H'_5$, $H'_6$ + $H'_7$

7. System according to claim 6 for analysis and synthesis of a high quality sound signal sampled at frequency fe = 32 kHz, characterized in that the prototype filter is a low-pass non-recursive filter with a linear phase and having a pass-band [0, 1 kHz] with 96 coefficients, the four sub-bands being respectively:

0, 2 kHz
2 kHz 4 kHz
4 kHz 8 kHz
8 kHz 16 kHz

**Patentansprüche**

1. Numerisches Signalverarbeitungssystem umfassend eine Zerlegungsfilterbank ($H_K$), die es ermöglicht, ein ein bestimmtes Band fe/2 besetzendes, und bei der Frequenz fe abgetastetes, eingehendes Signal x in eine ganze Zahl H von Signalen zu zerlegen, welche in den benachbarten Unterbändern liegen und abgetastet sind, und eine Synthesefilterbank, die es ermöglicht, das eingehende Signal ausgehend von den besagten Signalen in den Unterbändern zu rekonstruieren, wobei die besagten Filterbänke jeweils aus einer geraden Anzahl N von Filtern der gleichen Breite bestehen, von denen jedes durch Modulation eines Tiefpaßprototypfilters gebildet ist, welches eine auf die Quadraturbedingungen in einem nur über die unmittelbar benachbarten Filter hinausgehenden Band antwortende symmetrische Impulsantwort und eine Antwort Null außerhalb dieses Bandes hat, bei welchem die Filter ($H_K$) der Zerlegungsbank zusammengefaßt sind, um M Verbundfilter (Gi) zu bilden, welche jeweils eine Anzahl li von Filtern ($H_K$) umfassen, die sich von einem Verbundfilter (Gi) zum anderen unterscheiden, wobei die Werte Ni = N/li ganzzahlig sind, die Unter-Abtastung für jedes Filter (Gi) bei einer unterschiedlichen Frequenz fe/Ni durchgeführt wird; und alle Filter gleicher Breite, derart zusammengefaßt werden, daß die Unter-Abtast-Faktoren (Ni) die Bedingung

Ni = $m_i$ . Nm

erfüllen, wobei Nm der kleinste Unter-Abtast-Faktor der Filterbank Gi ist, und $m_i$ eine ganze Zahl ist, um zu ermöglichen, daß alle Berechnungen bei der gleichen Frequenz durchgeführt werden, wobei die Filter der Synthesebank einen symmetrischen Aufbau haben.

2. System nach Anspruch 1,
**dadurch gekennzeichnet**, daß
die Zerlegungsbank umfaßt: Ein polyphasiges Netz (22) mit N Eingängen; Mittel (24), um die 2N Ausgangssignale des Netzes einer ungeraden Kosinustransformation mit 2N Dimensionen zu unterziehen; und Mittel (26) zur erneuten Unter-Abtastung und zur Summierung der N Ausgangswerte x der besagten Transformationsmittel.

3. System nach Anspruch 2
**dadurch gekennzeichnet**, daß
die Synthesebank umfaßt: Mittel (28) zur Unter-Abtastung und zur Verteilung der aus der Zerlegungsbank kommenden M Signale $x_0,...,x_{M-1}$; Mittel (30), um die aus den Unter-Abtastmitteln kommenden Signale $\tilde{y}_0,..., \tilde{y}_{N-1}$ einer ungeraden Kosinustransformation zu unterziehen; ein polyphasiges Netz (32) mit 2N Eingängen und einen Addierer (34) der Ausgangssignale des besagten Netzes.

4. System nach einem der vorhergehenden Ansprüche,
**dadurch gekennzeichnet**, daß
das Prototypfilter eine Bandbreite [0, $\pi/8$] hat, mit $\pi$ = fe/2 und sowohl die Zerlegungs- als auch die Synthesebank vier Filter ($H_K$) oder ($H'_K$) gleicher Breite umfaßt, jede der Bänke (Gi) bei der Emission und (G'i) beim Empfang drei Filter umfaßt, jeweils
$H_0$, $H_1$, ($H_2$ + $H_3$)/2
$H'_0$, $H'_1$, $H'_2$ + $H'_3$

5. System nach einem der Ansprüche, 1-3,
**dadurch gekennzeichnet**, daß
das Prototypfilter eine Bandbreite [0, $\pi/12$] hat, mit $\pi$ = fe/2 und sowohl die Zerlegungs- als auch die Synthesebank sechs Filter ($H_K$) oder ($H'_K$) gleicher Breite umfaßt, jede der Bänke (Gi) bei der Emission und (G'i) beim Empfang vier Filter umfaßt, jeweils

$H_0$, $H_1$, $(H_2 + H_3)/2$, $(H_4 + H_5)/2$

$H'_0$, $H'_1$, $H'_2 + H'_3$, $H'_4 + H'_5$

6. System nach einem der Ansprüche, 1-3,

**dadurch gekennzeichnet**, daß

das Prototypfilter eine Bandbreite $[0, \pi/16]$ hat, mit $\pi$ = fe/2 und sowohl die Zerlegungs- als auch die Synthesebank acht Filter ($H_K$) oder ($H'_K$) gleicher Breite umfaßt, jede der Bänke (Gi) bei der Emission und (G'i) beim Empfang vier Filter umfaßt, jeweils

$H_0$, $H_1$, $(H_2 + H_3)/2$, $(H_4 + H_5 + H_6 + H_7)/4$

$H'_0$, $H'_1$, $H'_2 + H'_3$, $H'_4 + H'_5$, $H'_6 + H'_7$

7. System nach Anspruch 6 zur Zerlegung-Synthese eines Tonsignals hoher Qualität, welches bei der Frequenz fe = 32 kHz abgetastet ist,

**dadurch gekennzeichnet**, daß

das Prototypfilter ein nicht rekursives Tiefpaßfilter linearer Phase der Bandbreite [0,1 kHz] mit 96 Koeffizienten ist, wobei die vier Unterbänder jeweils:

0, 2 kHz

2 kHz 4 kHz

4 kHz 8 kHz

8 kHz 16 kHz

sind.

# FIG.1

# FIG.2

$H_K(\omega)$

$K\pi/N$ — $(K+1)\pi/N$

$\omega$

$\pi$

# FIG.3

$Y_K(\omega)$

$u=3$ | $u=0$ | $u=4$

$N=8, K=3$

$\omega$

$\pi$

# FIG.5

$X_i(\omega)$

$u=2$ | $u=0$ | $u=3$ | $u=1$ | $u=0$ | $u=2$

$0$ | $\pi/N$

$N=8, K_i=1, \ell_i=2$

$\omega$

$\pi$

FIG.4

FIG.6

FIG. 7

FIG. 8

FIG. 9

FIG.10

EP 0 285 495 B1

FIG. 11

$H^2_K(w); K = 0, 7$

FIG. 12

$H^2(w)$

EP 0 285 495 B1

FIG.13A

# FIG.13B

$x_0$

p=0

x(n)

p=1

s=1

$x_1$

$h_{15}$   $-h_{31}$   $h_{49}$   $-h_{63}$   $h_{79}$   $-h_{95}$

X

$h_{13}$   $-h_{29}$   $h_{47}$   $-h_{61}$   $h_{77}$   $-h_{93}$

X

$h_1$   $-h_{17}$   $h_{33}$   $-h_{49}$   $h_{65}$   $-h_{81}$

X

EP 0 285 495 B1

FIG.14 A

p = 0

EP 0 285 495 B1

# FIG.14B

p = 1

# FIG.15

EP 0 285 495 B1

# FIG.16

$B_0, fe/8$ —— $x_0$ —— $\boxed{\uparrow 4}$ —— $\tilde{y}_0, fe/2$

$B_1, fe/8$ —— $x_1$ —— $\boxed{\uparrow 4}$ —— $\tilde{y}_1, fe/2$

$B_2, fe/4$ —— $x_2$ —— $\boxed{\uparrow 2}$ —— $\tilde{y}_2, fe/2$

$\tilde{y}_3, fe/2$

$\tilde{y}_4, fe/2$

$\tilde{y}_5, fe/2$

$B_3, fe/2$ —— $x_3$ —— $\tilde{y}_6, fe/2$

$\tilde{y}_7, fe/2$

FIG.17A
p=0

# FIG.17B

$p = 1$

EP 0 285 495 B1

FIG.18A

(p=0)

EP 0 285 495 B1

# FIG.18B

$\widetilde{Y}_0^1$

$R_1^0$     $h_1$    $h_{17}$    $h_{33}$    $h_{49}$    $h_{65}$    $h_{81}$

$\widetilde{Y}_1^1$

$R_1^1$     $h_3$    $h_{19}$    $h_{45}$    $h_{51}$    $h_{67}$    $h_{83}$

$\widetilde{Y}_7^1$

$R_1^7$     $h_{15}$    $h_{31}$    $h_{47}$    $h_{63}$    $h_{79}$    $h_{95}$

(p=1)

$\widetilde{x}(2m+1)$

EP 0 285 495 B1